# EUROPEAN PATENT SPECIFICATION

(11) **EP 0 327 336 B1**
(45) Date of publication and mention of the grant of the patent: **10.12.1997**
(21) Application number: 89300962.1
(22) Date of filing: 01.02.1989
(51) Int. Cl.: H01L 23/373, H01L 23/29

(54) **Electronic devices incorporating carbon films**
Elektronische Anordnungen mit Kohlenstoffschichten
Dispositifs électroniques comprenant des couches de carbones

(30) Priority: 01.02.1988 JP 22381/88; 01.02.1988 JP 22382/88; 01.02.1988 JP 22383/88
(43) Date of publication of application: 09.08.1989
(73) Proprietor: SEMICONDUCTOR ENERGY LABORATORY CO., LTD., Atsugi-shi Kanagawa-ken, 243 (JP)
(72) Inventor: Yamazaki, Shunpei, Tokyo (JP)
(74) Representative: Milhench, Howard Leslie

(56) References cited:
- EP-A- 0 163 074
- EP-A- 0 221 531
- EP-A- 0 284 218
- US-A- 4 254 426
- R.C.A. REVIEW, vol. 43, no. 4, December 1982, pages 665-674, Princeton, New Jersey, US; J. ZELEZ: "A diamond-like carbon film"
- R.A. Meyers (ed.), Encyclopedia of Physical Science and Technology, Academic Press, Orlando, Florida, US, 1987, vol. 6, pages 691-693

## Description

### BACKGROUND OF THE INVENTION

The present invention relates to electronic devices incorporating carbon films and more particularly concerns devices provided with carbon pattern structures and manufacturing methods for the same.

Recently, a process for forming carbon films having very high hardness has been developed utilizing chemical vapour reactions. In EP-A-0 221 531 a method of producing a high heat conductive electrically insulated substrate is disclosed. The substrate is coated with an electrically insulating diamond-like carbon film having a high thermal conductivity, by a process of chemical vapour deposition. Carbon films of this type are very useful due to their high hardness and high thermal conductivity and can provide a smooth and corrosion-proof surface together with good thermal dissipation. These advantages, however, are countered by the fact that etching becomes difficult and, as will be well appreciated, etching processes are very important particularly in the field of semiconductor device manufacture.

### SUMMARY OF THE INVENTION

According to the present invention there is provided a method of forming a patterned hard carbon layer, said method including the formation of a high hardness amorphous or diamond-like carbon layer and being characterized in that said carbon layer is patterned by covering said layer with a pattern mask and exposing the layer through the mask to a chemical vapour etching reaction in a reaction chamber using an oxygen-containing etchant energized by high-frequency electrical energy, said pattern mask being made of a material resistant to said oxygen-containing etchant.

In a preferred embodiment, the etching is associated with a chemical vapour reaction in an oxygen containing etchant gas energized by high-frequency electrical energy at 50W to 5KW. The preferred carbon film is a so-called diamond-like carbon film whose Vickers hardness is about 6500 kg/mm² or higher depending upon its formation conditions. The energy gap of the film desirably is not lower than 1.0 eV, and preferably is from 1.5 to 5.5 eV. When used in integrated circuits or semiconductor devices, the high thermal conductivity of the carbon film assists the dissipation of heat generated in the integrated circuit or semiconductor device.

Other features of the invention are set forth with particularity in the appended claims and, together with the abovementioned features, will be well understood by consideration of the following particular description given with reference to the accompanying drawings illustrating exemplary embodiments of the invention.

### BRIEF DESCRIPTION OF THE DRAWINGS

Fig.1 is a schematic diagram showing a chemical vapour reaction apparatus useable in the practice of the present invention;
Figs.2(A) and 2(B) are cross-sectional views showing a method of fabricating carbon patterns in accordance with the present invention;
Figs.3(A) to 3(C) are cross-sectional views showing stages in the fabrication of a semiconductor device incorporating a carbon film pattern in accordance with the present invention; and
Figs.4,5 and 6 are cross-sectional views showing modifications of the embodiment illustrated in Figs.3(A) to 3(C).

### DETAILED DESCRIPTION OF THE EMBODIMENTS

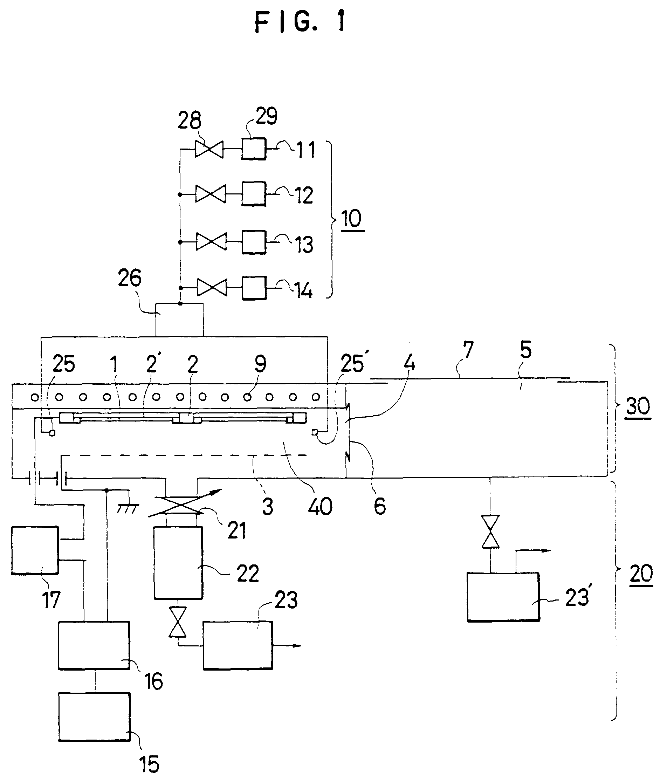

Referring to Fig.1, this shows a CVD (Chemical Vapour Deposition) apparatus which comprises a loading and unloading chamber 5, a reaction chamber 4 connected to the loading chamber 5 by way of a gate valve 6, a vacuum pump 23' for evacuating the loading chamber 5, a vacuum system for evacuating the reaction chamber 4 and consisting of a pressure control valve 21, a turbomolecular pump 22 and a rotary pump 23, a gas supply system 10 for introducing process gas into the reaction chamber 4, a substrate holder 2 functioning also as an electrode, a mesh electrode 3, a substrate temperature controlling device 9 and a high frequency electric energy supply connected between the substrate holder 2 and the mesh electrode 3 and consisting of a high frequency power source 15, a matching transformer 16 and a bias applying device 17. Optionally, a microwave excitation device 25 may be provided in association with the gas supply system 10. The device 25 energizes the reactive gas supplied by the gas supply system 10 with microwave energy at 2.45 GHz and 200W to 2KW for example and can cause the deposition speed and the etching speed achievable in the apparatus to be increased by a factor of about 4 or 5.

A method of depositing carbon films by use of the apparatus of Fig.1 will now be described. Substrates to be coated are placed in the loading chamber 5. After evacuating the loading and reaction chamber 4 and 5, the substrates 1 are transferred to the reaction chamber 4 through the gate valve 6. A reactive gas is admitted to the reaction chamber 4 through the gas supply system 10. The reactive gas includes a carbon compound gas such as CH₄, C₂H₄, C₂H₂, CH₃OH or C₂H₅OH for example. H₂ and CH₄ are introduced through the line 11 and the line 12 respectively at a same rate.

High frequency electric energy is applied to the reactive gas from the high frequency power source 15 at 50W to 1KW. The power input is equivalent to a plasma energy of 0.03 to 3 W/cm². The high frequency energy is applied between the substrates 1 and the mesh electrode 3 and is backed by a dc bias of from -200V to +600V. The actual bias potential at the substrates 1 is -400 to +400V since a self bias voltage is spontaneously applied thereto even without the application of an external bias. When deposition is carried out without application of microwave energy from the microwave source 25 and a 100 to 300 V bias voltage is superimposed on the electric energy applied from source 15, the deposition speed is of the order of 10 to 20 nm/min. When deposition is carried out with the application of microwave energy and a 100 to 300 V bias voltage is superimposed on the electric energy applied from source 15, the deposition speed is of the order of 50 to 100 nm/min. The pressure of the reactive gas is maintained at 133 to 1.33 Pa (1 to 0.01 Torr), e.g. 13.3 Pa (0.1 Torr) in the reaction chamber 4. The substrate temperature is maintained at 150 to -100°C by means of the device 9. As a result, an amorphous carbon film is deposited on the substrates 1. The carbon film consists of an amorphous carbon which depending on the deposition conditions, may contain microcrystals of 0.5 to 20 nm diameter. The Vickers hardness of the carbon film is not lower than 2000 kg/mm² and the thermal conductivity is not lower than 2.5 W/cm deg, preferably 4.0 to 6.0 W/cm deg. The carbon film is characterized by C-C bonds of sp³. Exhausted gas is removed through the evacuating system 21 to 23.

Electric power at 1 GHz or a higher frequency, e.g. 2.45 GHz, can break C-H bonds while C-C, C=C can be broken at 0.1 to 50 MHz, e.g. 13.56 MHz. The amount of hydrogen involved in the carbon films is preferably not higher than 50 mol%. Optionally, it is useful to add an impurity such as phosphorus or boron in order to fabricate carbon n-type or p-type semiconductors.

After forming the carbon film it can be patterned by forming a mask on the film and introducing an etchant gas into the reaction chamber 4. The etchant gas may for example be O₂, air, NO₂, NO, N₂O, a mixture of oxygen and hydrogen, or some suitable oxygen compound. A plasma is generated in the same manner as in the deposition process. The substrate temperature is 100 to -100°C during etching. The pressure of the reactive gas is 0.01 to 1 Torr.

Other films may optionally be formed underlying or overlying the carbon film. The formation of the other films and their masking may be carried out in the same chamber or different chambers.

A number of specific examples within the ambit of the present invention will now be described.

### Example 1:

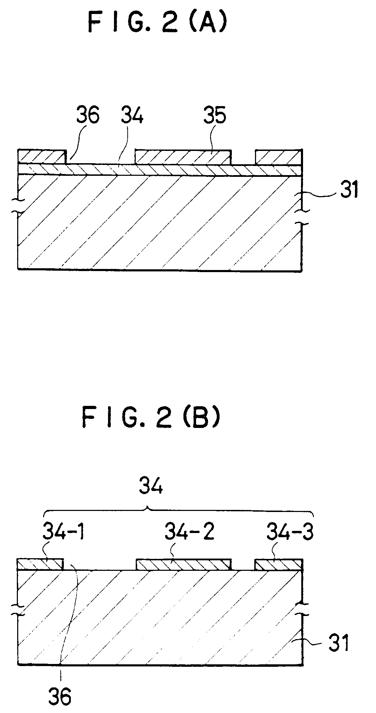

Reference is made to Figs.2(A) and 2(B). A carbon thin film pattern was formed on substrates made of a silicon semiconductor, a glass and a ceramic. A carbon film 34 was deposited on the substrate in accordance with the above method. Some surface portions of the carbon film were coated with a mask 35 corresponding to the prescribed pattern as shown in Fig.2(A). The mask 35 was made of silicon oxide, silicon nitride, a photoresist or the like. The etchant was O₂. The gas pressure was 13.3 Pa (0.1 Torr). The high frequency input power was 300 W. As a result, the carbon film was partially removed by etching at 35 nm/min. When the pressure was decreased to 6.6 Pa (0.05 Torr), the etching rate reduced to 27 nm/min. Finally, the mask was removed and a carbon pattern 34 was obtained as illustrated in Fig.2(B).

### Example 2:

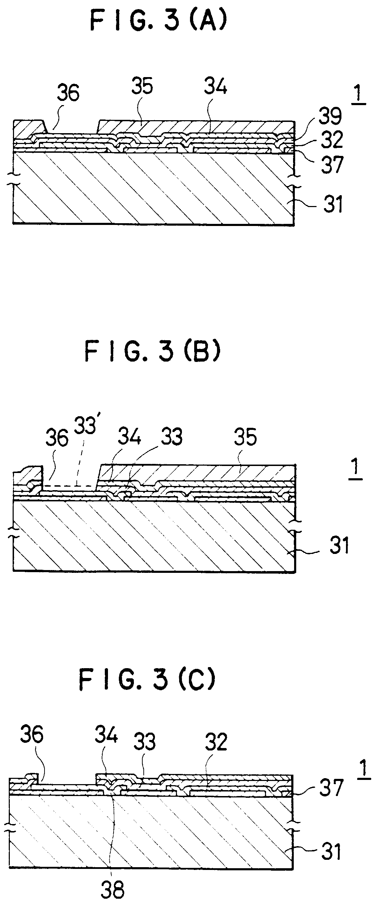

A semiconductor device including a carbon film pattern was produced. The process is explained in conjunction with Figs.3(A) to 3(C). The device was formed on a silicon semiconductor substrate 31. On the substrate, a silicon oxide film 37 and a superconducting ceramic film 32 were formed and patterned respectively, followed by a coating of 0.5 µm blocking film 33 which prevents the underlying film 32 from being exposed to etching. The blocking film 33 was made of SiO₂. Then, a carbon film 34 was deposited on the structure to a thickness of 0.1 to 2 µm, e.g. 0.5 µm. A photoresist pattern 35 was formed on the carbon film 34 with an opening 36. The opening 36 is a bonding pad or terminal portion for making contact with an IC chip. The thickness of the photoresist pattern was selected so that the underlying surface would not be exposed even if the photoresist layer was partially removed by the following etching.

Next, oxygen gas was introduced into the reaction chamber and high frequency power was inputted at 300W to perform etching of the carbon film 34. After completion of the etching, the photoresist 35 and the portion of the blocking film 34 that was exposed at the opening 36 was removed by etching using NF₃ or SF₆.

Alternatively, the conductive film 32 may be formed of Al, Ag or Si. The blocking film 33 may be formed of a phosphosilicate glass. The thickness of the blocking film may be 0.1 to 2 µm in general. Instead of the thick photoresist pattern, a silicon oxide pattern may be formed by coating the device with a silicon oxide film and etching the same by use of a photoresist Silicon oxide is not subject to etching by oxygen.

### Example 3:

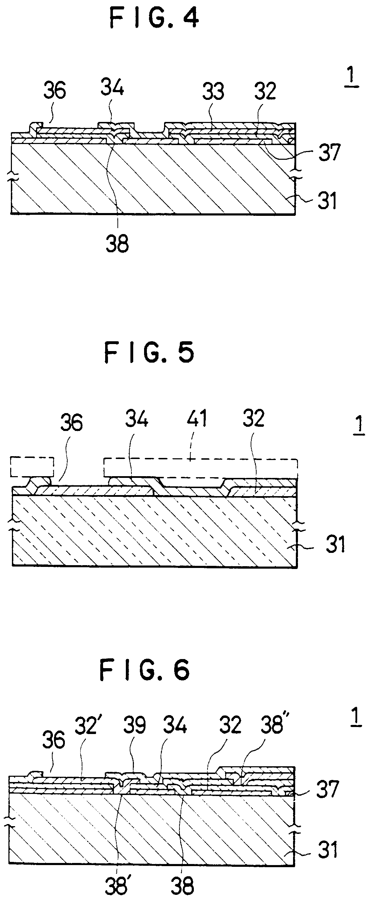

This is a modification of Example 2. In this example, the blocking film was made of a conductive material such as gold, platinum, chromium, a superconducting oxide material or silicon which was doped with an impurity. The conductive pattern 32 was made of aluminium, a metal silicate or silicon which was doped with an impurity. Optionally, a final coating of carbon film may be formed over the structure. In this embodiment, the blocking film 33 and the underlying pattern 32 were formed to coincide with each other as shown in Fig.4.

The structure of this example is very useful for IC chips since heat concentrations can be reduced by virtue of the high thermal conductivity of the carbon film.

### Example 4:

Fig.5 is referred to. A conductive film 32 was deposited on a glass substrate or a glazed substrate and photoetched in order to produce electrical conductors including pads for making contact with IC chips. A carbon film 34 was deposited to a thickness of 0.2 to 2 µm on the substrate over the pattern 32. Then, the carbon film 34 was etched with a stainless metal mask 41 of 50 to 500 µm thickness. This process is characterized by a decreased number of steps.

### Example 5:

This example was carried out substantially in accordance with the process of Example 2 except for the following differences. Reference is made to Fig.6. In this example, a second carbon film 39 was formed and patterned in the same manner as the carbon film pattern 34. Between the formations of the carbon film patterns 34 and 39, a second intervening electrode pattern 32' was formed by sputtering. The second electrode pattern 32' was prevented from making contact with other insulating films by the carbon films.

While several embodiments of the invention have been specifically described, it is to be appreciated that the present invention is not limited to the particular examples described and that modifications and variations can be made without departure from the scope of the invention as defined by the appended claims. Examples of such modifications are as follows.

An IC chip may be mounted on the laminate pattern providing bonding pads and including carbon films in accordance with the present invention, and the whole structure may be coated with a carbon film as a passivation film. The performance of the laminate pattern may be tested in advance of the mounting of the IC chip.

Superconducting ceramics for use in accordance with the present invention may be prepared to be consistent with the stoichiometric formulae (A₁₋ₓ Bₓ)_{y}Cu_{z}O_{w}, where A is one or more elements of Group IIIa of the Japanese Periodic Table, e.g. the rare earth elements, B is one or more elements of Group IIa of the Japanese Periodic Table, e.g. the alkaline earth elements, and x = 0.1 - 1; y =2.0 - 4.0, preferably 2.5 - 3.5; z = 1.0 - 4.0, preferably 1.5-3.5; and w = 4.0 - 10.0, preferably 6.0 - 8.0. Also, superconducting ceramics for use in accordance with the present invention may be prepared to be consistent with the stoichiometric formulae (A₁₋ₓBₓ)_{y}Cu_{z}O_{w}, where A is one or more elements of Group Vb of the Japanese Periodic Table such as Bi, Sb, and As; B is one or more elements of Group IIa of the Japanese Periodic Table, e.g. the alkaline earth elements, and x = 0.3-1; y = 2.0 - 4.0, preferably 2.5 - 3.5; z = 1.0-4.0, preferably 1.5 - 3.5; and w = 4.0 - 10.0, preferably 6.0 - 8.0. Examples of the latter general formulae are Bi₄Sr_{y}Ca₃Cu₄Oₓ, Bi₄Sr_{y}Ca₃Cu₄Oₓ, Bi₄Sr_{y}Ca₃Cu₄Oₓ, Bi₄Sr_{y}Ca₃Cu₄Oₓ, Bi₄Sr_{y}Ca₃Cu₄Oₓ, and Bi₄Sr_{y}Ca₃Cu₄Oₓ (y is around 1.5).

For the avoidance of doubt it is to be noted that all references herein and in the appended claims to the Periodic Table and to specific Groups of the Periodic Table are to be understood to refer to the Japanese Periodic Table and to the Groups thereof as described in the Iwanami "Physics and Chemistry Dictionary". As compared with the Group designations of the Periodic Table as described in "The Penguin Dictionary of Science" for example, which are the Group designations commonly accepted throughout Europe, Groups Ia, IIa, VIII, Ib, IIb and 0 are the same in the Japanese and European Periodic Tables, Groups IIIa, IVa, Va, VIa and VIIa of the Japanese Periodic Table correspond respectively to Groups IIIb, IVb, Vb, VIb and VIIb of the European Periodic Table, and Groups IIIb, IVb, Vb, VIb and VIIb of the Japanese Periodic Table correspond respectively to Groups IIIa, IVa, Va, VIa and VIIa of the European Periodic Table.

## Claims

1. A method of forming a patterned hard carbon layer, said method including the formation of a high hardness amorphous or diamond-like carbon layer (34) and being characterized in that said carbon layer (34) is patterned by covering said layer with a pattern mask (35) and exposing the layer through the mask to a chemical vapour etching reaction in a reaction chamber using an oxygen-containing etchant energized by high-frequency electrical energy, said pattern mask (35) being made of a material resistant to said oxygen-containing etchant.

2. A method according to claim 1, wherein said carbon layer (34) is formed on a semiconductor substrate (31), a glass substrate (31) or a ceramic substrate (31).

3. A method according to claim 1 or 2 wherein said carbon layer (34) is formed on a substrate (31) having electrical conductors (32) formed thereon.

4. A method according to claim 3 wherein said electrical conductors (32) comprise metal leads, silicon leads or superconductor leads.

5. A method according to any preceding claim wherein the formation of the high hardness amorphous or diamond-like carbon layer (34) comprises disposing a substrate in the reaction chamber, introducing a carbon containing reactive gas into the reaction chamber, applying electrical energy to said reactive gas and depositing said carbon layer (34) on said substrate (31).

6. A method according to any preceding claim wherein said chemical vapour etching reaction is effected in a plasma generated from said oxygen-containing etchant.

7. A method according to any preceding claim wherein said oxygen-containing etchant comprises O₂, NO₂, NO, N₂O or a mixture of oxygen, hydrogen and air.

8. A method according to any preceding claim wherein said pattern mask (35) is made of silicon oxide, silicon nitride, a photo-resist or a metal.

9. A method according to any preceding claim wherein said carbon layer (34) is part of an electronic device having at least one terminal portion (36) arranged to be electrically connectable to an external device, and said patterning is carried out such that said at least one terminal portion (36) is exposed.

10. A method according to any preceding claim, wherein said carbon layer (34) is part of an electronic device and an additional high hardness amorphous or diamond-like carbon layer (39) is formed on the external surface of the electronic device as a passivation film.

## Patentansprüche

1. Verfahren zum Erzeugen einer harten Kohlenstoffschicht mit einem Muster, wozu die Erzeugung einer amorphen oder diamantartigen Kohlenstoffschicht (34) hoher Härte gehört, dadurch gekennzeichnet, daß die Kohlenstoffschicht (34) mit einem Muster versehen wird, indem sie mit einer Mustermaske (35) beschichtet und durch diese hindurch einer Dampfphasen-Ätzreaktion in einer Reaktionskammer unter Verwendung eines sauerstoffhaltigen, mit elektrischer Hochfrequenzenergie beaufschlagten Ätzmittels unterzogen wird, wobei die Mustermaske (35) aus einem gegen das sauerstoffhaltige Ätzmittel beständigen Material besteht.

2. Verfahren nach Anspruch 1, wobei die Kohlenstoffschicht (34) auf einem Halbleiter-, Glas-, oder Keramiksubstrat (31) erzeugt wird.

3. Verfahren nach Anspruch 1 oder 2, wobei die Kohlenstoffschicht (34) auf einem mit elektrischen Leitern (32) versehenen Substrat (31) erzeugt wird.

4. Verfahren nach Anspruch 3, wobei die elektrischen Leiter (32) Metall-, Silicium- oder supraleitende Leiter umfassen.

5. Verfahren nach einem der vorhergehenden Ansprüche, wobei zur Erzeugung der amorphen oder diamantartigen Kohlenstoffschicht (34) hoher Härte ein Substrat in eine Reaktionskammer eingebracht, in die Kammer ein kohlenstoffhaltiges Reaktionsgas eingeleitet, das Reaktionsgas mit elektrischer Energie beaufschlagt und die Kohlenstoffschicht (34) auf dem Substrat (31) niedergeschlagen wird.

6. Verfahren nach einem der vorhergehenden Ansprüche, wobei die Dampfphasen-Ätzreaktion in einem aus dem sauerstoffhaltigen Ätzmittel erzeugten Plasma durchgeführt wird.

7. Verfahren nach einem der vorhergehenden Ansprüche, wobei das sauerstoffhaltige Ätzmittel O₂, NO₂, NO, N₂O oder ein Gemisch aus Sauerstoff, Wasserstoff und Luft enthält.

8. Verfahren nach einem der vorhergehenden Ansprüche, wobei die Mustermaske (35) aus Siliciumoxid, Siliciumnitrid, einem Photoresist oder Metall besteht.

9. Verfahren nach einem der vorhergehenden Ansprüche, wobei die Kohlenstoffschicht (34) Teil einer elektronischen Vorrichtung ist, die mindestens einen Anschluß (36) zur elektrischen Verbindung mit einem externen Gerät aufweist, und wobei die Musterbildung so durchgeführt wird, daß der mindestens eine Anschluß (36) frei liegt.

10. Verfahren nach einem der vorhergehenden Ansprüche, wobei die Kohlenstoffschicht (34) Teil einer elektronischen Vorrichtung ist, auf deren Außenfläche eine zusätzliche amorphe oder diamantartige Kohlenstoffschicht (39) hoher Härte als Passivierungsfilm erzeugt wird.

## Revendications

1. Procédé de formation d'une couche de carbone dur pourvue de motifs, ledit procédé comprenant la formation d'une couche (34) de carbone semblable à du diamant ou amorphe, de dureté élevée, et étant caractérisé en ce que l'on pourvoit ladite couche de carbone (34) de motifs en la recouvrant d'un masque à motifs (35) et en l'exposant à travers le masque à une réaction d'attaque chimique en phase vapeur dans une chambre de réaction, en utilisant un réactif d'attaque contenant de l'oxygène, activé par une énergie électrique à haute fréquence, ledit masque à motifs (35) étant fait d'une matière résistant audit réactif d'attaque contenant de l'oxygène.

2. Procédé selon la revendication 1, dans lequel ladite couche de carbone (34) est formée sur un substrat semiconducteur (31), un substrat de verre (31) ou un substrat de céramique (31).

3. Procédé selon la revendication 1 ou 2, dans lequel ladite couche de carbone (34) est formée sur un substrat (31) sur lequel des conducteurs électriques (32) sont formés.

4. Procédé selon la revendication 3, dans lequel lesdits conducteurs électriques (32) comprennent des conducteurs métalliques, des conducteurs de silicium ou des conducteurs supraconducteurs.

5. Procédé selon l'une quelconque des revendications précédentes, dans lequel la formation de la couche de carbone (34) semblable à du diamant ou amorphe, de dureté élevée, comprend le positionnement d'un substrat dans la chambre de réaction, l'introduction d'un gaz réactif contenant du carbone dans la chambre de réaction, l'application d'énergie électrique audit gaz réactif et le dépôt de ladite couche de carbone (34) sur ledit substrat (31).

6. Procédé selon l'une quelconque des revendications précédentes, dans lequel ladite réaction d'attaque chimique en phase vapeur est effectuée dans un plasma produit à partir dudit réactif d'attaque contenant de l'oxygène.

7. Procédé selon l'une quelconque des revendications précédentes, dans lequel ledit réactif d'attaque contenant de l'oxygène comprend de l'O₂, du NO₂, du NO, du N₂O ou un mélange d'oxygène, d'hydrogène et d'air.

8. Procédé selon l'une quelconque des revendications précédentes, dans lequel ledit masque à motifs (35) est fait d'oxyde de silicium, de nitrure de silicium, d'un photorésist ou d'un métal.

9. Procédé selon l'une quelconque des revendications précédentes, dans lequel ladite couche de carbone (34) fait partie d'un composant électronique ayant au moins une partie formant borne (36) conçue pour pouvoir être reliée électriquement à un dispositif externe, ladite formation des motifs étant exécutée de sorte que ladite partie formant borne (36) soit apparente.

10. Procédé selon l'une quelconque des revendications précédentes, dans lequel ladite couche de carbone (34) fait partie d'un composant électronique et une couche supplémentaire (39) de carbone semblable à du diamant ou amorphe, de dureté élevée, est formée sur la surface externe du composant électronique en tant que film de passivation.
